# EUROPEAN PATENT SPECIFICATION

(11) **EP 3 614 161 B1**
(45) Date of publication and mention of the grant of the patent: **12.08.2026**
(21) Application number: 18189973.3
(22) Date of filing: 21.08.2018
(51) Int. Cl.: G01R 33/38

(54) **METHOD OF RAMPING A MAGNET FOR A MAGNETIC RESONANCE IMAGING APPARATUS**
VERFAHREN ZUM HOCHFAHREN EINES MAGNETEN FÜR EINE MAGNETRESONANZBILDGEBUNGSVORRICHTUNG
PROCÉDÉ DE MONTÉE EN PUISSANCE D'UN AIMANT D'UN APPAREIL D'IMAGERIE PAR RÉSONANCE MAGNÉTIQUE

(43) Date of publication of application: 26.02.2020
(73) Proprietor: Siemens Healthineers AG, 91301 Forchheim (DE)
(72) Inventor: BIBER, Stephan, 91056 Erlangen (DE); POTTHAST, Andreas, 91052 Erlangen (DE); VESTER, Markus, 90471 Nürnberg (DE); NISTLER, Jürgen, 91056 Erlangen (DE); DE OLIVEIRA, Andre, 91080 Uttenreuth (DE); MODEL, Volker, 90766 Fürth (DE); BAMPTON, Adrian, Sutton Courteney OX14 4AX Abingdon (GB); JOHNSTONE, Adam, OX9 3BH Thame (GB)
(74) Representative: Siemens Healthineers Patent Attorneys

(56) References cited:
- WO-A1-2017/203330
- US-A1- 2005 111 159

## Description

The invention describes a method of operating an MRI apparatus. The invention further describes an MRI apparatus.

Developments in the field of magnetic resonance imaging (MRI) systems have led to advances in low-field systems, which can be preferred on account of their smaller footprint. Low-field systems can be open-bore, can allow interventional procedures, and are less expensive. The term "low-field system" generally refers to a system that has a magnetic field strength of at most 1.0 Tesla. An MRI system with a magnetic field strength in excess of 1.0 Tesla is generally referred to as a "high-field system". The magnetic field strength of the low-field systems currently in development may be even lower than 1.0 Tesla, and may even be lower than 0.5 Tesla.

When an MRI system is first installed on site, a ramping procedure is carried out to set up the main magnetic field (also referred to as the static background field) in the main coil windings. After the initial installation ramping procedure, shim coils are used to perform any adjustments necessary to take into account the local environment.

Usually, the target frequency (i.e. the centre frequency of the main magnet) is determined with the aid of a probe placed at a suitable position in the apparatus. To allow for the inevitable decay of the magnetic field arising from component aging, typically in the order of several hundred ppm per year, this target frequency generally exceeds the centre frequency of the body coil by an amount that is sufficient to ensure that the centre frequency of the main magnetic field remains above the body coil centre frequency for as long as possible.

In any superconducting MRI system, decay of the magnetic field is unavoidable due to the residual electrical resistance of the magnet. Field decay means that the centre frequency of the main magnetic field gradually drifts away from the initial setting. Ultimately, it becomes necessary to re-ramp the system. In a high-field system, the bandwidth of the body coil and radio-frequency system is so large (e.g. body coil bandwidth ± 100 kHz or more) that it can take several years before field decay is out of specification. Generally, another service procedure such as a cold head exchange must be scheduled sooner. To carry out such a service procedure, the magnet must in any case be ramped down and up, so an opportunity is given to re-calibrate the system.

Before ramping the magnet, a target frequency for the main magnetic field is identified. It is usual to set the highest possible target frequency and to use the shim coils for any fine-tuning of the main magnetic field. By setting the highest possible target frequency, the decay window (the time taken for the frequency to drift to the lower end of the allowed band) is made as long as possible. This approach is suitable for systems with a high bandwidth as explained above. However, the bandwidth of a low-field system is significantly narrower than that of a high-field system, being only in the order of 10 kHz - 25 kHz, so that prior art methods of setting the magnet target frequency are limited to a much shorter "decay window". Because the decay window is narrower, the magnet frequency of a low-field MRI system decays towards an out-of-spec level in a shorter space of time. This means that low-field MRI systems must generally be ramped more often.

Ideally, the centre frequency of the body coil would be the same as the frequency of the main magnet field. However, with a low-field magnet, reflection effects reduce the accuracy of the system and the centre frequency is lower.

The first superconducting low-field MRI systems were generally realised as vertical field systems, characterized by a relatively inefficient body coil. These early low-field vertical systems are known to be less reliable than a comparable horizontal field system (with a birdcage body coil), so that service checks must be scheduled relatively frequently. During these service procedures, the frequency of the main magnetic field is checked and the system is re-ramped if necessary. In a low-field system, it may be necessary to carry out an intermittent ramping procedure, for example in the event of an infrastructure problem such as a loss of power or problems with a cooling issues arrangement, etc.

The document WO 2017/203330 A1 discloses systems and methods for magnetic resonance imaging ("MRI") of multiple different nuclear spin species using the same radio frequency ("RF") coil. Generally, multiple different nuclear spin species are imaged using the same RF coil by using an MRI system whose magnetic field can be rapidly ramped between a number of different, and arbitrary, magnetic field strengths. The magnetic field of this MRI system can be ramped to different values in reasonable amounts of time (e.g., in a time frame that is feasible within an imaging study).

From document US 2005/011159 A1, a novel technique for placing superconducting magnets into operation is known. For example, the technique provides for automatically controlling ramp-up of a superconducting magnet. In one aspect, the technique includes connecting a power supply to the magnet, determining constraining parameters of the ramp-up automatically applying power to the magnet, automatically controlling the ramp-up based on the constraining parameters, and wherein the ramp-up is complete upon reaching a predetermined value of a target parameter.

The object of the invention is to provide a way of ramping an MRI apparatus that overcomes the problems outlined above.

This object is achieved by the method of claim 1 of operating an MRI apparatus, and by the MRI apparatus of claim 4.

According to the invention, the method of operating an MRI apparatus comprises the steps of computing a first magnet target frequency on the basis of a first tolerance window; computing a second magnet target frequency on the basis of a second tolerance window, which second tolerance window exceeds the first tolerance window; selecting one of the magnet target frequencies; and, at a scheduled time, ramping the magnet of the MRI apparatus to the selected magnet target frequency. Further details of the inventive method are defined in claim 1.

A target frequency for a ramping procedure is constrained by the upper boundary of the tolerance window defined by the bandwidth of the radio-frequency system as explained above.

In the context of the invention, the first tolerance window shall be understood to have a different bandwidth than the second tolerance window, i.e. one tolerance window is narrower than the other. The two possible target frequencies will therefore also be different. Depending on the nature of the scheduled ramping procedure, the more appropriate of the two target frequencies is selected and used during the ramping procedure.

It may be assumed that the tolerance windows differ significantly, i.e. that the width of the first tolerance windows differs from the width of the second tolerance window by a significant amount, for example by at least 10 kHz - 100 kHz.

The magnet is ramped at a scheduled time, whereby this is to be understood to mean that the magnet field is monitored continually during operation of the MRI apparatus, and when it is detected that the magnet field has decayed to a level approaching a lower limit, an alert may be issued to an operator who can then schedule a ramp procedure at the next convenient opportunity.

According to the invention, the MRI apparatus comprises a magnet, a body coil, and modules to perform steps of the inventive method, as defined in claim 4.

The first tolerance window is used when the magnet is to be ramped to a high degree of precision using a field probe, for example. Alternatively, the first tolerance window is used when the magnet is to be ramped using an array shim device (a specific arrangement of field probes that is used during an initial installation procedure to establish a shim plot). This type of ramping procedure is more accurate but it takes long time for the magnet to reach the higher first target frequency. Such ramping procedures generally require expertise and are performed by qualified personnel.

The second target frequency is selected when the magnet is to be ramped in the absence of an MR echo frequency, i.e. without using a field probe or measuring a reflected signal from the body coil, or when the ramp procedure is to be performed without any user interaction. For example, a ramp procedure towards the second frequency may be performed using only the magnet power supply (MPSU), i.e. by using an economical but inaccurate shunt to measure the current or voltage of the MPSU while ramping and estimating the momentary value of the magnet frequency to determine when the ramp sequence is complete. This less accurate ramping procedure takes a shorter time to reach the lower second target frequency, and may be preferred when a user is not available to give user input, as may occur when the magnet is to be ramped autonomously. An example of such a scenario might be when the magnet is to be ramped up after a power or cooling outage that resulted in the magnet being ramped down, since power is requires for the cooling system. When power returns and the cooling system is once again operating reliable, the magnet can be autonomously ramped up without requiring any user to be present.

The tolerance windows to be used for the different target frequencies can be predefined, i.e. defined by the manufacturer. The various parameters that define suitable tolerance windows can be supplied to the customer and may be stored in the system or may be delivered with the system hardware, for example.

A target frequency is defined by the upper boundary of the body coil RF bandwidth and the appropriate tolerance window. This ensures that the target frequency is always the highest possible for the next scheduled ramping event. This helps to increase the average interval between ramp events over the lifetime of the MRI system and to reduce the system downtime. An advantage of the inventive MRI apparatus is that it can be significantly more economical to run, since the time interval between consecutive ramping events can be extended, resulting in less downtime (during which MRI scans cannot be performed) .

The units or modules of the MRI apparatus mentioned above, in particular the frequency determination unit and the selection unit, can be completely or partially realised as software modules running on a processor of a control unit of an MRI apparatus. A realisation largely in the form of software modules can have the advantage that applications already installed on an existing MRI system can be updated, with relatively little effort, to carry out the method steps of the present application. The object of the invention is also achieved by a computer program product with a computer program that is directly loadable into the memory of a control unit of an MRI apparatus according to the invention, and which comprises program units to perform the steps of the inventive method when the program is executed by the control unit. In addition to the computer program, such a computer program product can also comprise further parts such as documentation and/or additional components, also hardware components such as a hardware key (dongle etc.) to facilitate access to the software.

A computer readable medium such as a memory stick, a hard-disk or other transportable or permanently-installed carrier can serve to transport and/or to store the executable parts of the computer program product so that these can be read from a processor unit of an MRI apparatus. A processor unit can comprise one or more microprocessors or their equivalents.

Particularly advantageous embodiments and features of the invention are given by the dependent claims, as revealed in the following description.

The inventive method can be applied in any appropriate MRI apparatus, for example in an MRI apparatus that has a superconducting magnet, a permanent magnet, or an electromagnet. However, a low-field MRI apparatus with a superconducting magnet benefits to a greater extent from the inventive method. In the following therefore, but without restricting the invention in any way, it may be assumed that the magnet of the MRI apparatus is a superconductive magnet. It may also be assumed that the MRI apparatus is a low-field MRI apparatus. In a particularly preferred embodiment of the invention, the field strength of the magnet is at most 1.0 T, more preferably at most 0.3 T. As indicated above, the RF bandwidth of a mid- or high-field MRI apparatus is generally very large, but the bandwidth of a low-field apparatus is significantly narrower and may be as small as 10 kHz, for example. In a further preferred embodiment of the invention, the MRI apparatus has a body coil with a RF bandwidth that does not exceed 50 kHz.

As explained above, the first tolerance window has a different bandwidth than the second tolerance window. In a further preferred embodiment of the invention, the first tolerance window is comparatively narrow and is applied when it is possible to precisely determine the magnet frequency. Preferably, the first tolerance window has a bandwidth of at most 5 kHz, more preferably at most 0.1 kHz. The first tolerance window can be applied when the magnet frequency can be estimated using a field probe, for example. By placing a field probe at a suitable position in the MRI apparatus, for example in the homogeneity volume or even into the isocenter of the B0 field, it is possible to establish a direct relationship between the current and/or voltage at the power supply and the detected echo frequency, thereby allowing the magnet frequency to be determined to a high degree of accuracy. The magnet can therefore be ramped to a target frequency near the upper boundary of the narrow tolerance window. Ramping to a higher target frequency will ensure a longer duration (i.e. a wider decay window) before the magnet frequency decays to a lower limit.

In a further preferred embodiment of the invention, the second tolerance window is comparatively wide and has a bandwidth of at most 50 kHz, more preferably at most 10 kHz. The second tolerance window therefore results in a lower target frequency. While this may appear to be a disadvantage, the inventors have realised that the advantage of being able to estimate the magnet frequency using a low accuracy shunt and performing a significantly shorter ramp procedure can outweigh the disadvantage of the shorter decay window.

The upper boundary of the RF bandwidth can be either set as a fixed parameter or it can be measured during tune-up or during a manufacturing stage. It can stored in software, for example as a system parameter. Alternatively, the upper boundary of the RF bandwidth can be an individual parameter which is specified with a major hardware component e.g. the body coil and is then read out from there by the central control system.

An advantage of the invention is that either a first or a second ramping mechanism can be selected based on user input, or the system can establish which of the two ramping mechanisms is most appropriate, depending on which hardware is connected to the system. For example, the presence of a shim array probe can be automatically recognized from a coil code that can be read by the MRI controller, which will then automatically select the narrower tolerance window. Ramp-up will be performed using a field probes or the shim array device, and the reading of the MPSU sensor or shunt can be calibrated from the frequency measurement.

In one preferred embodiment of the invention, during the ramp procedure, the magnet frequency is determined on the basis of the magnet current as measured by a current sensor. The current sensor preferably comprises an ammeter shunt connected between MPSU and magnet. An ammeter shunt can measure large current values by means of a known and very small resistor in parallel with a moving coil galvanometer. Such an ammeter shunt is advantageously economical, with a significant inaccuracy when new, for example in the order of 500 ppm. The inaccuracy can increase even further to 5,000 ppm as a result of long-term aging effects. The magnet frequency can be derived from the current measured by the shunt. Owing to the relatively poor accuracy of the shunt, the measured magnet current may deviate from the magnet actual current by 500 - 5,000 ppm, so that the derived magnet frequency will deviate from the actual magnet frequency by 500 - 5,000 ppm. Even so, this rough estimation of the magnet frequency can allow a target frequency to be determined for a ramp procedure. Using such a rough estimate for the magnet current is a trade-off against the longer time it would take to ramp to a higher target frequency.

As an alternative to using a low-accuracy current sensor to estimate the magnet current and to derive the magnet frequency, the magnet frequency can be estimated on the basis of a field measurement from a Hall sensor. Here also, the magnet frequency is derived in a comparatively inaccurate manner, since a Hall sensor can generally only measure the B0 field to within a limited accuracy, and the estimated field strength may differ by 500 - 50,000 ppm from the actual field strength.

Other objects and features of the present invention will become apparent from the following detailed descriptions considered in conjunction with the accompanying drawings. It is to be understood, however, that the drawings are designed solely for the purposes of illustration and not as a definition of the limits of the invention.
Fig 1 shows a simplified circuit diagram of a superconductive low-field MRI apparatus according to an embodiment of the invention;
Fig 2 shows a simplified block diagram of an MRI apparatus according to an embodiment of the invention;
Fig 3 illustrates the determination of a target frequency based on a narrow tolerance window;
Fig 4 illustrates the determination of a target frequency based on a wide tolerance window.

In the diagrams, like numbers refer to like objects throughout. Objects in the diagrams are not necessarily drawn to scale.

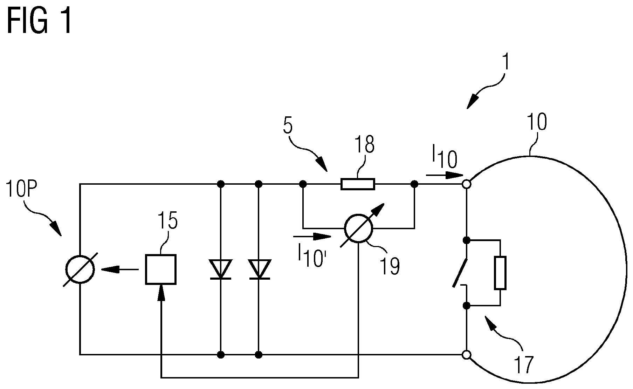

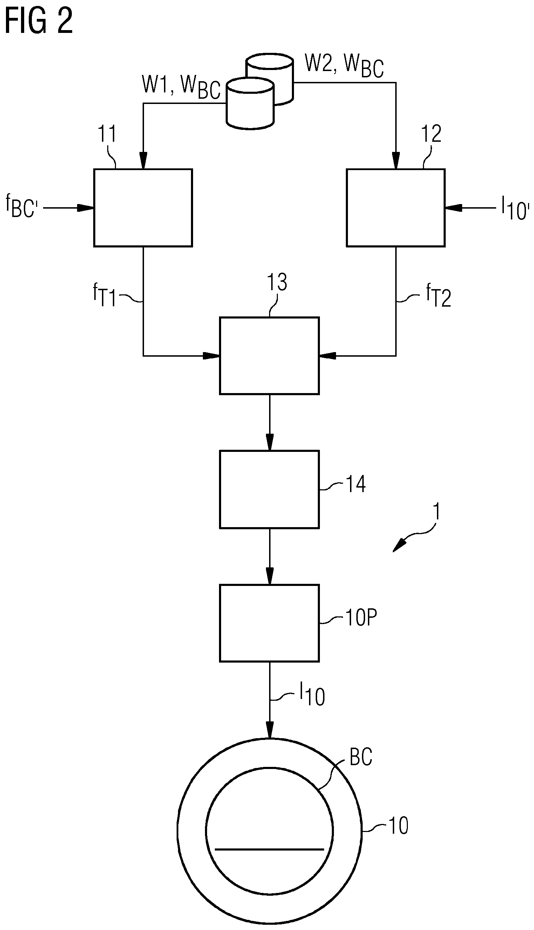

Fig 1 shows a greatly simplified circuit diagram of a superconductive low-field MRI apparatus 1. The apparatus comprises a main magnet 10 that generates a very homogenous main magnetic field B0. Fig 2 shows a simplified block diagram of an MRI apparatus 1 indicating the main magnet 10. The usual arrangement of additional i.e. a body coil BC, a shim coil, and a number of gradient coils may be assumed to be present. An MPSU 10P is used to supply current I₁₀ to the magnet 10 during a ramp-up procedure. A switch assembly 17 comprising a superconducting switch in parallel with a bypass resistor is shown connected across the main magnet coil. The switch is closed during the ramp-up procedure so that a small amount of current passes through the bypass resistor. When the desired magnetic field strength has been reached, the switch is opened.

In this exemplary embodiment, the current sensor S is realised as an ammeter shunt and comprises a shunt 18 and a galvanometer 19 arranged to measure current through the shunt 18. The measured current I₁₀' corresponds essentially to the current I₁₀ through the magnet 10. Adjusting for the slight loss through the shunt, the magnet current I₁₀ can be determined to an accuracy of 500 - 5,000 ppm. The current sensor components will age over time, and this aging may be quantified and used to adjust the measured current value as appropriate.

An MRI system 1 comprises various modules and units, most of which will be known to the skilled person and need not be explained here. The system 1 can be delivered with a set of parameters such as a body coil RF bandwidth W_{BC} and tolerance windows W1, W2 for use in computation of a target frequency. Any such parameters can be stored in a suitable memory module. Fig 2 shows two frequency determination modules 11, 12 each of which is realised to identify a magnet target frequency f_{T1}, f_{T2} on the basis of a tolerance window W1, W2, a body coil RF bandwidth W_{BC}, and an appropriate input variable. To compute the higher first target frequency f_{T1'} the input variable to the first frequency determination module 11 is a measured RF signal f_{BC}' reflected from the body coil BC when a probe is placed inside the body coil BC during ramp-up. To compute the lower second target frequency f_{T2}, the input variable to the second frequency determination module 12 is magnet current I₁₀' measured by the ammeter shunt S.

A selection module 13 is provided to select one of the computed magnet target frequencies f_{T1'} f_{T2} as appropriate for the next re-ramp procedure. A ramp control module 14 is provided to initiate a ramping procedure to ramp the main magnet 10 to the selected magnet target frequency f_{T1'} f_{T2}. The units and modules can be realized as part of a central control system of the MRI apparatus 1.

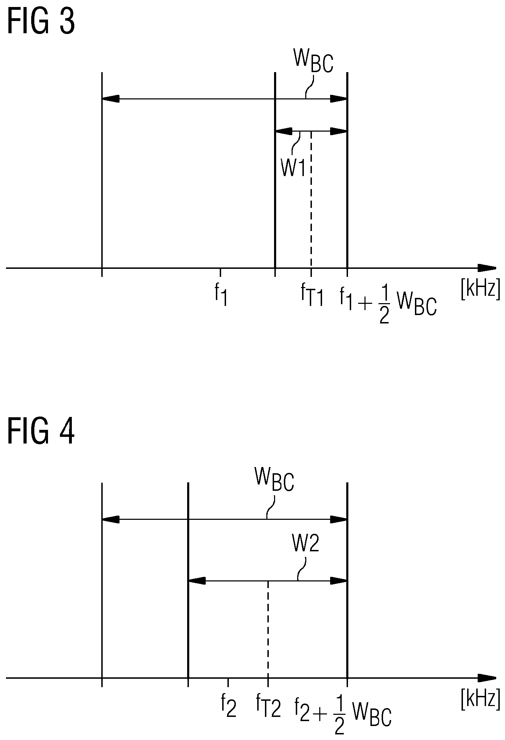

Fig 3 is a graph of amplitude against frequency, illustrating the computation of a target frequency f_{T1} for a ramping procedure, based on a narrow tolerance window W1. In this case the upper boundary of the body coil radio-frequency bandwidth W_{BC} can be either set as a fixed parameter or it can be measured during a tuning procedure or during a manufacturing stage. For example, the body coil RF bandwidth W_{BC} may be in the order of 50 kHz. This information can be stored in software as a system parameter, or can be a parameter which is delivered with the body coil, for example in a memory module such as an EEPROM or a flash memory that is part of the body coil system. The body coil RF bandwidth W_{BC} can be read out from such a memory module by a controller of the MRI apparatus.

In this comparatively accurate method, a probe is placed in the body coil BC and the magnet frequency f₁ is calculated.

The first target frequency f_{T1} can then be expressed as ${f}_{T 1} = {f}_{1} + \frac{1}{2} {W}_{BC} - \frac{1}{2} W 1$

To give an example, the frequency f₁ of the magnet may be estimated using a probe to be about 20 MHz. Using a known body coil RF bandwidth W_{BC} of 30 kHz and the known narrow window W1 of 1 kHz, the target frequency f_{T1} for the next ramp event is determined to be 20.014500 MHz using equation (1).

Fig 4 is a graph of amplitude against frequency, illustrating the computation of a second target frequency f_{T2} for a ramping procedure, based on a wide tolerance window W2. The upper boundary of the radio-frequency bandwidth W_{BC} is known as explained in Fig 3 above. The wide tolerance window W2 is also known. The magnet frequency f₂ is estimated using the comparatively inaccurate current I₁₀' measured using the shunt S of Fig 1.

The second target frequency f_{T2} can then be expressed as ${f}_{T 2} = {f}_{2} + \frac{1}{2} {W}_{BC} - \frac{1}{2} W 2$

To give an example, the frequency f₂ of the magnet may be estimated using the shunt to be about 20 MHz. Using a known body coil RF bandwidth W_{BC} of 30 kHz and the known wide window W2 of 10 kHz, the target frequency f_{T2} for the next ramp event is determined to be 20.01 MHz using equation (2). This roughly computed target frequency f_{T2} can be used when an autonomous ramp-up sequence is to be performed, or when there is no user available to place a field probe, for example.

Although the present invention has been disclosed in the form of preferred embodiments and variations thereon, it will be understood that numerous additional modifications and variations could be made thereto without departing from the scope of the invention, which is defined by the claims.

For the sake of clarity, it is to be understood that the use of "a" or "an" throughout this application does not exclude a plurality, and "comprising" does not exclude other steps or elements. The mention of a "unit" or a "module" does not preclude the use of more than one unit or module.

## Claims

1. A method of operating an MRI apparatus (1), the MRI apparatus comprising a magnet (10) and a body coil, which method comprises the steps of
- computing a first magnet target frequency, f_{T1}, on the basis of a first tolerance window W1; and
- computing a second magnet target frequency, f_{T2}, on the basis of a second tolerance window W2
- selecting one of the magnet target frequencies (f_{T1}, f_{T2}); and
- ramping the magnet (10) of the MRI apparatus (1) at a scheduled time to the selected magnet target frequency (f_{T1}, f_{T2}) ;
**characterized by**
the first target frequency f_{T1} being expressed by ${f}_{T 1} = {f}_{1} + \frac{1}{2} {W}_{BC} - \frac{1}{2} W 1 ;$
the second target frequency f_{T2} being expressed by ${f}_{T 2} = {f}_{2} + \frac{1}{2} {W}_{BC} - \frac{1}{2} W 2 ;$
wherein W_{BC} is the body coil bandwidth, *f*₁ and *f*₂ are the magnet frequency,
wherein the second tolerance window exceeds the first tolerance window,
wherein the first magnet target frequency (fT1) is selected when the magnet frequency (f1) is determined in a comparatively more accurate manner using a probe during the ramp procedure,
wherein the probe comprises a field probe,
wherein the second target frequency (fT2) is selected when the magnet frequency (f2) is determined in a comparatively more inaccurate manner during the ramp procedure using a current sensor or a Hall sensor.

2. A method according to claim 1, wherein the first tolerance window (W1) has a bandwidth of at most 5 kHz, more preferably at most 0.1 kHz.

3. A method according to claim 1 or claim 2, wherein the second tolerance window (W2) has a bandwidth of at least 10 kHz, more preferably at least 20 kHz, and preferably at most 50 kHz.

4. An MRI apparatus (1) comprising
- a magnet (10)
- a body coil
- a first frequency determination module (11) for identifying a first magnet target frequency, f_{T1}, on the basis of a first tolerance window W1
- a second frequency determination module (12) for identifying a second magnet target frequency, f_{T2}, on the basis of a second tolerance window W2
- a selection module (13) realised to select one of the magnet target frequencies (fT1, fT2); and
- a ramp module (14) to initiate a ramping procedure to ramp the magnet (10) at a scheduled time to the selected magnet target frequency (fta1, fta2);
**characterized by**
the first target frequency f_{T1} being expressed by ${f}_{T 1} = {f}_{1} + \frac{1}{2} {W}_{BC} - \frac{1}{2} W 1 ;$
the second target frequency f_{T2} being expressed by ${f}_{T 2} = {f}_{2} + \frac{1}{2} {W}_{BC} - \frac{1}{2} W 2 ;$
wherein
W_{BC} is the body coil bandwidth, *f*₁ and *f*₂ are the magnet frequency, wherein the second tolerance window exceeds the first tolerance window,
wherein the selection module is configured to select the first magnet target frequency (fT1) when the magnet frequency (f1) is to be determined in a comparatively more accurate manner using a probe during the ramp procedure,
wherein the probe comprises a field probe,
wherein the selection module is configured to select the second target frequency (fT2) when the magnet frequency (f2) is to be determined in a comparatively more inaccurate manner during the ramp procedure using a current sensor or a Hall sensor.

5. An MRI apparatus according to claim 4, wherein the magnet (10) of the MRI apparatus (1) is designed to have a field strength of at most 1.0 Tesla, more preferably at most 0.7 Tesla, most preferably at most 0.5 Tesla.

6. An MRI apparatus according to claim 4 or claim 5, wherein the magnet (10) is a superconductive magnet.

7. An MRI apparatus according to any of claims 4 to 6, comprising a current sensor (S) arranged to measure magnet current (I₁₀), which current sensor comprises an ammeter shunt (S) with a long-term measurement accuracy in the region of 500 - 10,000 ppm.

8. An MRI apparatus according to any of claims 4 to 7, wherein the bandwidth of the body coil comprises at most 50 kHz.

9. A computer program product comprising a computer program that is directly loadable into a memory of a control unit of an MRI apparatus (1) according to any of claims 4 to 7 and which comprises program elements for performing the steps of the method according to any of claims 1 to 3 when the computer program is executed by the control unit.

10. A computer-readable medium on which is stored a computer program comprising program elements that can be read and executed by a control unit of an MRI apparatus (1) according to any of claims 4 to 7 in order to perform the steps of the method according to any of claims 1 to 3 when the program elements are executed by the control unit.

## Patentansprüche

1. Verfahren zum Betreiben einer MRI-Einrichtung (1), wobei die MRI-Einrichtung einen Magneten (10) und eine Körperspule umfasst, wobei das Verfahren die folgenden Schritte umfasst:
- Berechnen einer ersten Magnetzielfrequenz f_{T1} basierend auf einem ersten Toleranzfenster W1; und
- Berechnen einer zweiten Magnetzielfrequenz f_{T2} basierend auf einem zweiten Toleranzfenster W2;
- Auswählen einer der Magnetzielfrequenzen (f_{T1}, f_{T2}); und
- rampenartiges Hochfahren des Magneten (10) der MRI-Einrichtung (1) zu einer geplanten Zeit auf die ausgewählte Magnetzielfrequenz (f_{T1}, f_{T2});
**gekennzeichnet durch**
die erste Zielfrequenz f_{T1}, die ausgedrückt wird durch ${f}_{T 1} = {f}_{1} + \frac{1}{2} {W}_{BC} - \frac{1}{2} W 1 ;$
die zweite Zielfrequenz f_{T2}, die ausgedrückt wird durch ${f}_{T 2} = {f}_{2} + \frac{1}{2} {W}_{BC} - \frac{1}{2} W 2 ;$
wobei W_{BC} die Körperspulenbandbreite ist, f₁ und f₂ die Magnetfrequenz sind,
wobei das zweite Toleranzfenster das erste Toleranzfenster überschreitet,
wobei die erste Magnetzielfrequenz (fT1) ausgewählt wird, wenn die Magnetfrequenz (f1) auf eine vergleichsweise genauere Weise unter Verwendung einer Sonde während der Rampenprozedur bestimmt wird,
wobei die Sonde eine Feldsonde umfasst,
wobei die zweite Zielfrequenz (fT2) ausgewählt wird, wenn die Magnetfrequenz (f2) auf eine vergleichsweise ungenauere Weise während der Rampenprozedur unter Verwendung eines Stromsensors oder eines Hall-Sensors bestimmt wird.

2. Verfahren nach Anspruch 1, wobei das erste Toleranzfenster (W1) eine Bandbreite von höchstens 5 kHz, bevorzugter von höchstens 0,1 kHz aufweist.

3. Verfahren nach Anspruch 1 oder Anspruch 2, wobei das zweite Toleranzfenster (W2) eine Bandbreite von wenigstens 10 kHz, bevorzugter wenigstens 20 kHz und vorzugsweise höchstens 50 kHz aufweist.

4. MRT-Einrichtung (1), umfassend:
- einen Magneten (10)
- eine Körperspule
- ein erstes Frequenzbestimmungsmodul (11) zum Identifizieren einer ersten Magnetzielfrequenz f_{T1} basierend auf einem ersten Toleranzfensters W1;
- ein zweites Frequenzbestimmungsmodul (12) zum Identifizieren einer zweiten Magnetzielfrequenz f_{T2} basierend auf einem zweiten Toleranzfensters W2;
- ein Auswahlmodul (13), das dazu realisiert ist, eine der Magnetzielfrequenzen (fT1, fT2) auszuwählen; und
- ein Rampenmodul (14) zum Einleiten einer Rampenprozedur zum rampenartigen Hochfahren des Magneten (10) zu einer geplanten Zeit auf die ausgewählte Magnetzielfrequenz (fta1, fta2); **gekennzeichnet durch**
die erste Zielfrequenz f_{T1}, die ausgedrückt wird durch ${f}_{T 1} = {f}_{1} + \frac{1}{2} {W}_{BC} - \frac{1}{2} W 1 ;$
die zweite Zielfrequenz f_{T2}, die ausgedrückt wird durch ${f}_{T 2} = {f}_{2} + \frac{1}{2} {W}_{BC} - \frac{1}{2} W 2 ;$
wobei W_{BC} die Körperspulenbandbreite ist, f₁ und f₂ die Magnetfrequenz sind, wobei das zweite Toleranzfenster das erste Toleranzfenster überschreitet,
wobei das Auswahlmodul dazu ausgelegt ist, die erste Magnetzielfrequenz (fT1) auszuwählen, wenn die Magnetfrequenz (f1) auf eine vergleichsweise genauere Weise unter Verwendung einer Sonde während der Rampenprozedur bestimmt werden soll, wobei die Sonde eine Feldsonde umfasst,
wobei das Auswahlmodul dazu ausgelegt ist, die zweite Zielfrequenz (fT2) auszuwählen, wenn die Magnetfrequenz (f2) auf eine vergleichsweise ungenauere Weise während der Rampenprozedur unter Verwendung eines Stromsensors oder eines Hall-Sensors bestimmt werden soll.

5. MRT-Einrichtung nach Anspruch 4, wobei der Magnet (10) der MRT-Einrichtung (1) dazu gestaltet ist, eine Feldstärke von höchstens 1,0 Tesla, bevorzugter höchstens 0,7 Tesla, besonders bevorzugt höchstens 0,5 Tesla aufzuweisen.

6. MRI-Einrichtung nach Anspruch 4 oder Anspruch 5, wobei der Magnet (10) ein supraleitender Magnet ist.

7. MRI-Einrichtung nach einem der Ansprüche 4 bis 6, umfassend einen Stromsensor (S), der zum Messen eines Magnetstroms (I₁₀) eingerichtet ist, wobei der Stromsensor einen Amperemeter-Shunt (S) mit einer Langzeitmessgenauigkeit in dem Bereich von 500 - 10.000 ppm umfasst.

8. MRI-Einrichtung nach einem der Ansprüche 4 bis 7, wobei die Bandbreite der Körperspule höchstens 50 kHz umfasst.

9. Computerprogrammprodukt, umfassend ein Computerprogramm, das direkt in einen Speicher der Steuereinheit einer MRT-Einrichtung (1) nach einem der Ansprüche 4 bis 7 ladbar ist, und das Programmelemente zum Durchführen der Schritte des Verfahrens nach einem der Ansprüche 1 bis 3 umfasst, wenn das Computerprogramm durch die Steuereinheit ausgeführt wird.

10. Computerlesbares Medium, auf dem ein Computerprogramm gespeichert ist, umfassend Programmelemente, die durch eine Steuereinheit einer MRI-Einrichtung (1) nach einem der Ansprüche 4 bis 7 gelesen und ausgeführt werden können, um die Schritte des Verfahrens nach einem der Ansprüche 1 bis 3 auszuführen, wenn die Programmelemente durch die Steuereinheit ausgeführt werden.

## Revendications

1. Un procédé pour faire fonctionner une installation (1) d'IRM, l'installation d'IRM comprenant un aimant (10) et une bobine de corps, lequel procédé comprend les stades de
- calculer une première fréquence f_{T1} cible de l'aimant, sur la base d'une première fenêtre W1 de tolérance ; et
- calculer une deuxième fréquence f_{T2} cible de l'aimant, sur la base d'une deuxième fenêtre W2 de tolérance ;
- sélectionner l'une des fréquences (f_{T1}, f_{T2}) cibles de l'aimant ;
et
- faire aller l'aimant (10) de l'installation (1) d'IRM en un temps planifié en rampe à la fréquence (f_{T1}, f_{T2}) cible sélectionnée de l'aimant ;
**caractérisé par**
la première fréquence f_{T1} cible étant exprimée par ${f}_{T 1} = {f}_{1} + \frac{1}{2} {W}_{BC} - \frac{1}{2} W 1 ;$
la deuxième fréquence f_{T2} cible étant exprimée par ${f}_{T 2} = {f}_{2} + \frac{1}{2} {W}_{BC} - \frac{1}{2} W 2 ;$
dans lesquelles
W_{BC} est la largeur de bande de la bobine de corps, *f*₁ et *f*₂ sont la fréquence de l'aimant,
dans lequel la deuxième fenêtre de tolérance excède la première fenêtre de tolérance,
dans lequel la première fréquence (fT1) cible de l'aimant est sélectionnée, lorsque la fréquence (f1) de l'aimant est déterminée d'une manière comparativement plus précise en utilisant une sonde pendant la procédure de rampe,
dans lequel la sonde comprend une sonde de champ,
dans lequel la deuxième fréquence (fT2) cible est sélectionnée, lorsque la fréquence (f2) de l'aimant est déterminée d'une manière comparativement plus imprécise pendant la procédure de rampe en utilisant un capteur de courant ou un capteur de Hall.

2. Un procédé suivant la revendication 1, dans lequel la première fenêtre (W1) de tolérance a une largeur de bande d'au plus 5 kHz, d'une manière plus préférée d'au plus 0,1 kHz.

3. Un procédé suivant la revendication 1 ou la revendication 2, dans lequel la deuxième fenêtre (W2) de tolérance a une largeur de bande d'au moins 10 kHz, d'une manière plus préférée d'au moins 20 kHz, et de manière préférée d'au plus 50 kHz.

4. Une installation (1) d'IRM comprenant
- un aimant (10),
- une bobine de corps,
- un première module (11) de détermination de fréquence pour identifier une première fréquence f_{T1} cible de l'aimant, sur la base d'une première fenêtre W1 de tolérance ;
- un deuxième module (12) de détermination de fréquence pour identifier une deuxième fréquence f_{T2} cible de l'aimant, sur la base d'une deuxième fenêtre W2 de tolérance ;
- un module (13) de sélection réalisé pour sélectionner l'une des fréquences (fT1, fT2) cibles de l'aimant ; et
- un module (14) de rampe pour initier une procédure pour faire aller l'aimant (10) en un temps planifié à la fréquence (fta1, fta2) cible sélectionnée de l'aimant ;
**caractérisée par**
la première fréquence f_{T1} cible étant exprimée par ${f}_{T 1} = {f}_{1} + \frac{1}{2} {W}_{BC} - \frac{1}{2} W 1 ;$
la deuxième fréquence f_{T2} cible étant exprimée par ${f}_{T 2} = {f}_{2} + \frac{1}{2} {W}_{BC} - \frac{1}{2} W 2 ;$
dans lesquelles
W_{BC} est la largeur de bande de la bobine de corps, *f*₁ et *f*₂ sont la fréquence de l'aimant, dans laquelle la deuxième fenêtre de tolérance excède la première fenêtre de tolérance,
dans laquelle le module de sélection est configuré pour sélectionner la première fréquence (fT1) cible de l'aimant, lorsque la fréquence (f1) de l'aimant doit être déterminée d'une manière comparativement plus précise en utilisant une sonde pendant la procédure de rampe,
dans laquelle la sonde comprend une sonde de champ,
dans laquelle le module de sélection est configuré pour sélectionner la deuxième fréquence (fT2) cible, lorsque la fréquence (f2) de l'aimant doit être déterminée d'une manière comparativement plus imprécise pendant la procédure de rampe en utilisant un capteur de courant ou un capteur de Hall.

5. Une installation d'IRM suivant la revendication 4, dans laquelle l'aimant (10) de l'installation (1) d'IRM est conçu pour avoir une intensité du champ d'au plus 1,0 Tesla, d'une manière plus préférée d'au plus 0,7 Tesla, d'une manière très préférée d'au plus 0,5 Tesla.

6. Une installation d'IRM suivant la revendication 4 ou la revendication 5, dans laquelle l'aimant (10) est un aimant supraconducteur.

7. Une installation d'IRM suivant l'une quelconque des revendications 4 à 6, comprenant un capteur (S) de courant agencé pour mesurer un courant (I₁₀) d'aimant, lequel capteur de courant comprend un shunt (S) d'ampèremètre ayant une précision de mesure de longue durée dans la région de 500 à 10 000 ppm.

8. Une installation d'IRM suivant l'une quelconque des revendications 4 à 7, dans laquelle la largeur de bande de la bobine de corps comprend au moins 50 kHz.

9. Un produit de programme d'ordinateur comprenant un programme d'ordinateur, qui peut être chargé directement dans une mémoire d'une unité de commande d'une installation (1) d'IRM suivant l'une quelconque des revendications 4 à 7, et qui comprend des éléments de programme pour effectuer les stades du procédé suivant l'une quelconque des revendications 1 à 3, lorsque le programme d'ordinateur est exécuté par l'unité de commande.

10. Un support déchiffrable par ordinateur, sur lequel est mis en mémoire un programme d'ordinateur comprenant des éléments de programme, qui peuvent être déchiffrés et exécutés par une unité de commande d'une installation (1) d'IRM suivant l'une quelconque des revendications 4 à 7, afin d'effectuer les stades du procédé suivant l'une quelconque des revendications 1 à 3, lorsque les éléments du programme sont exécutés par l'unité de commande.
